# FASCICULE DE BREVET EUROPEEN

(11) **EP 1 507 286 B1**
(45) Date de publication et mention de la délivrance du brevet: **09.12.2015**
(21) Numéro de dépôt: 04103813.4
(22) Date de dépôt: 06.08.2004
(51) Int. Cl.: H01L 21/027, H01L 21/768, H01L 29/423, H01L 29/66, H01L 29/786

(54) **Procédé de formation d'un réseau d'interconnexions d'un circuit intégré et procédé de formation d'un transistor à grille entourante**
Herstellungsverfahren einer Netzwerkverbindung einer integrierten Schaltung und Herstellungsverfahren eines Transistors mit umschliessendem Gate
Method of forming an interconnection network of an integrated circuit and methof of forming a surrounding gate transistor

(30) Priorité: 12.08.2003 FR 0350425
(43) Date de publication de la demande: 16.02.2005
(73) Titulaire: Commissariat à l'Énergie Atomique et aux Énergies Alternatives, 75015 Paris (FR)
(72) Inventeur: CORONEL, Philippe, 38530, BARRAUX (FR); LAPLANCHE, Yves, 38920, CROLLES (FR); PAIN, Laurent, 38500, SAINT NICOLAS DE MACHERIN (FR)
(74) Mandataire: Thibon, Laurent

(56) Documents cités:
- EP-A1- 1 091 417
- FR-A- 2 693 030
- US-A- 4 557 995
- US-A- 4 595 649
- US-A1- 2003 064 577
- PERSSON M, PETTERSSON J: "Submicron air-bridge interconnection process for complex gate geometries" J. VAC. SCI. TECHNOL. B, MICROELECTRON. NANOMETER STRUCT., vol. 15, no. 5, septembre 1997 (1997-09), pages 1724-1727, XP002283979
- CHIU G T ET AL: "ELECTRON DISCHARGING FOR ELECTRONBEAM EXPOSURE" IBM TECHNICAL DISCLOSURE BULLETIN, IBM CORP. NEW YORK, US, vol. 27, no. 8, janvier 1985 (1985-01), page 5014, XP000807789 ISSN: 0018-8689

## Description

La présente invention concerne un procédé de formation d'un réseau d'interconnexions d'un circuit intégré, et un procédé de formation d'un transistor à grille entourante, dans lesquels on vise plus particulièrement à former sous une couche d'un premier matériau des portions d'un autre matériau.

Des techniques connues d'implantation ionique permettent de former des couches enterrées dans un substrat en faisant réagir des ions implantés avec le substrat. Un exemple d'implantation ionique est l'implantation d'oxygène O₂ dans un substrat de silicium afin de former des couches enterrées d'oxyde de silicium SiO₂.

Cette technique d'implantation est néanmoins relativement destructrice pour la partie supérieure du substrat. De plus, elle ne permet pas de former une couche enterrée de n'importe quel type de matériau. En outre, l'épaisseur de la couche enterrée est difficilement contrôlable.

Une autre technique connue de formation de couches enterrées est celle mise en oeuvre par exemple lors de la formation de dispositifs de type "silicium sur rien", ou SON (de l'anglais Silicon On Nothing). Après croissance épitaxiale d'une couche de silicium/germanium puis d'une couche de silicium, on grave une ou plusieurs portions de la couche de silicium afin de pouvoir éliminer par gravure la couche de silicium/germanium sous-jacente. On dépose ensuite une couche diélectrique ou conductrice sous la couche de silicium en remplissant l'espace précédemment occupé par la couche de silicium/germanium.

Une fois la couche déposée, aucune technique connue ne permet d'éliminer des portions choisies de la couche diélectrique ou conductrice. Un inconvénient de cette technique est donc que la couche déposée a nécessairement une forme identique à la couche de silicium/germanium.

FR-A-2 693 030 décrit un procédé de formation d'une zone de vide sous une couche d'un matériau donné, non photosensible.

US 2003/064577 Al décrit un procédé de formation d'un réseau d'interconnexions d'un circuit intégré.

EP 1 091 417 Al décrit un procédé de formation d'un transistor à grille entourante.

La présente invention prévoit un procédé de formation d'un réseau d'interconnexions selon la revendication 1.

La présente invention prévoit aussi un procédé de formation d'un transistor à grille entourante selon la revendication 2.

Ces objets, caractéristiques et avantages, ainsi que d'autres de la présente invention seront exposés en détail dans la description suivante de modes de réalisation particuliers en relation avec les figures jointes parmi lesquelles :
les figures 1A à 1D sont des vues en coupe de structures obtenues après des étapes successives d'un procédé ne faisant pas partie de la présente invention ;
la figure 2 est une vue en perspective d'une structure intermédiaire obtenue lors d'un procédé classique de formation de dispositifs de type SON ;
les figures 3A à 3F sont des vues en coupe de structures obtenues après des étapes successives selon la présente invention afin de former un transistor à grille entourante ; et
les figures 4A à 4F sont des vues en coupe de structures obtenues après des étapes successives d'un autre exemple selon la présente invention, afin de former un réseau d'interconnexions d'un circuit intégré.

Par souci de clarté, les mêmes éléments ont été désignés par les mêmes références aux différentes figures et, de plus, comme cela est habituel dans la représentation des circuits intégrés, les figures ne sont pas tracées à l'échelle.

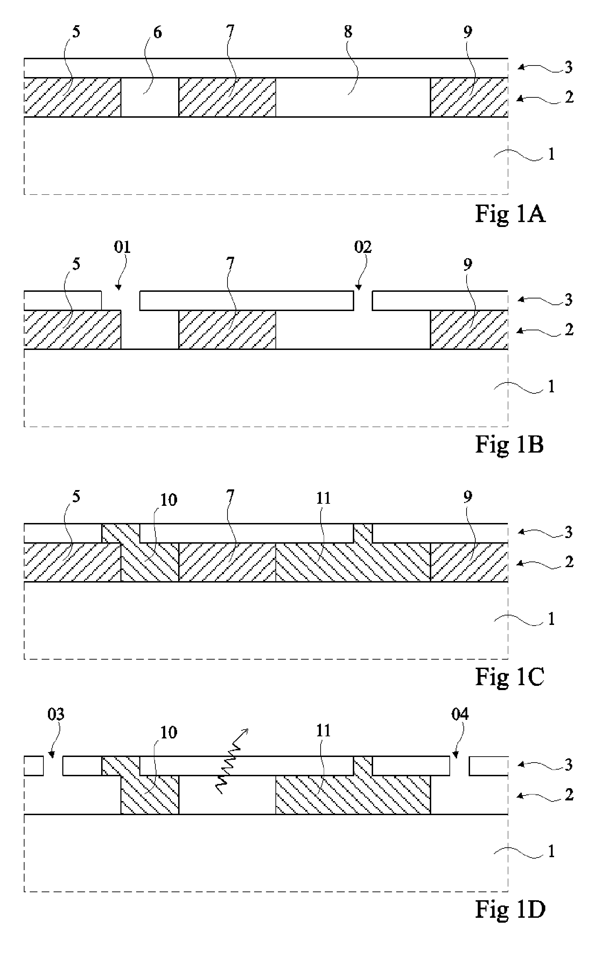

Les aspects généraux communs des procédés de la présente invention sont décrits en relation aux figures 1A à 1D. Des exemples de mise en oeuvre de ces aspects généraux sont décrits ensuite pour la réalisation d'un transistor de type SON et pour la réalisation d'un réseau d'interconnexions permettant de relier les composants d'un circuit les uns aux autres.

Dans une étape initiale, illustrée en figure 1A, on forme sur un substrat 1 un empilement d'une couche photosensible 2 et d'une couche mince 3 d'un matériau donné. Le substrat 1 peut être n'importe quelle structure obtenue après une étape d'un procédé standard de formation de circuits intégrés. L'empilement de la couche photosensible 2 et de la couche mince 3 peut être obtenu selon divers procédés comme cela apparaîtra dans les exemples de mise en oeuvre du procédé de la présente invention décrits ci-après. La couche mince 3 peut être composée d'un matériau diélectrique, semiconducteur ou conducteur.

On effectue une insolation d'une ou de plusieurs portions de la couche photosensible 2 avec un faisceau d'électrons passant à travers la couche mince 3. La profondeur de pénétration du faisceau d'électrons à travers la couche mince 3, la couche photosensible 2 et éventuellement le substrat 1 dépend de l'énergie d'accélération des électrons, de l'épaisseur respective des couches et de leurs natures. L'homme de l'art saura définir les épaisseurs des couches 2 et 3 ainsi que l'énergie d'accélération du faisceau d'électrons permettant d'insoler la couche photosensible 2 tout en assurant que le faisceau d'électrons reste cohérent en traversant la couche mince 3 afin d'avoir une bonne définition des portions insolées. A titre d'exemple, avec une couche mince 3 de silicium d'épaisseur 100 nm et une énergie d'accélération de 50 keV, les portions insolées de la couche photosensible peuvent être définies avec une précision inférieure à 10 nm.

En figure 1A, on a représenté cinq portions 5, 6, 7, 8 et 9 de gauche à droite. Dans le cas où la couche photosensible est positive, on insole les portions 6 et 8. Dans le cas où la couche photosensible est négative, on insole les portions 5, 7 et 9.

Après insolation, on élimine les portions insolées (ou non insolées selon le cas), ici les portions 6 et 8. Divers procédés peuvent être mise en oeuvre.

Dans le cas où le type de couche photosensible choisi le permet, on pourra éliminer les portions 6 et 8 par un procédé "d'évaporation". Ce procédé consiste à placer la structure dans un plasma qui a pour effet de modifier la structure des portions 6 et 8 sans modifier celle des portions 5, 7 et 9. Le plasma utilisé peut être un plasma d'oxygène (O₂), d'hydrogène (H₂) ou d'azote (N₂). Après modification de la structure des portions de la couche photosensible 6 et 8, la couche photosensible s'élimine en passant à travers la couche mince 3.

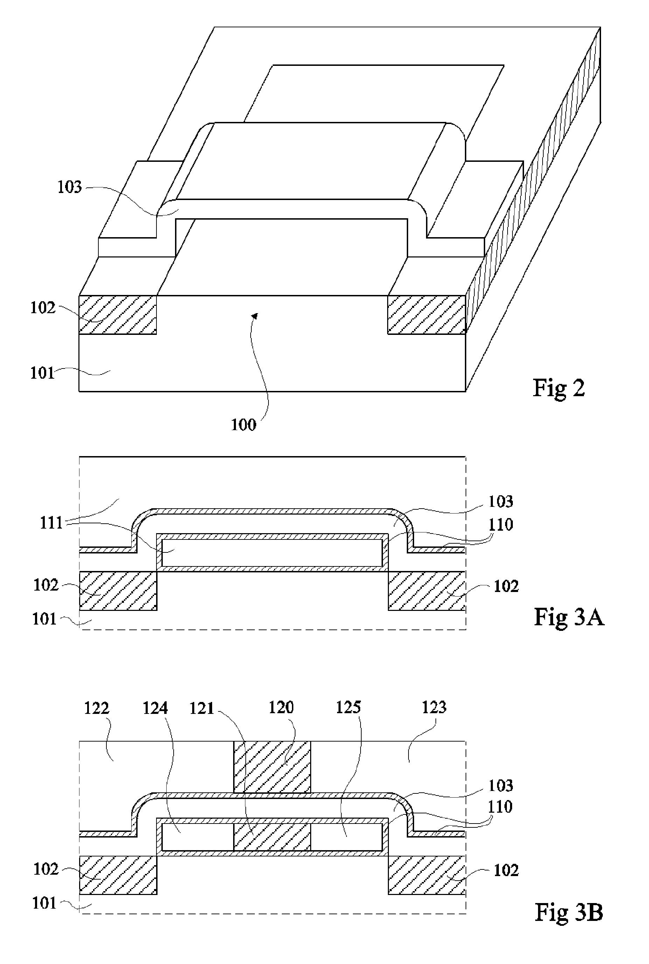

Un autre procédé d'élimination des portions de la couche photosensible 6 et 8 est illustré en figure 1B. On forme des ouvertures 01 et 02 dans la couche mince 3 au-dessus des portions 6 et 8. Dans cet exemple, l'ouverture 01 est formée au-dessus de la partie de gauche de la portion 6 et se prolonge au-dessus de la partie de droite de la portion 5. L'ouverture O2 est formée au-dessus de la partie centrale de la portion 8. On élimine ensuite les portions 6 et 8 de la couche photosensible par un développement sélectif. Dans l'exemple représenté en figure 1B, des ouvertures de la couche mince 3 ont été réalisées au-dessus de chacune des portions de la couche photosensible 2 que l'on souhaite éliminer. Cependant, dans certaines structures telles que celle décrite ci-après en relation aux figures 3A à 3F, il est possible que les portions de la couche photosensible que l'on souhaite supprimer soient accessibles "de côté". Dans ce cas il n'est pas indispensable de former des ouvertures préalablement à l'élimination de certaines portions de la couche photosensible.

Dans le cas où l'on a formé des ouvertures O1 et O2, on pourra prévoir une étape supplémentaire, illustrée en figure 1C, consistant à remplir l'espace précédemment occupé par les portions 6 et 8 d'un deuxième matériau différent de celui de la couche mince 3. On a ainsi formé des portions 10 et 11 du deuxième matériau sous la couche mince 3.

Dans le cas où les évidements sous la couche mince 3 ont été formés par un développement chimique sélectif et où ces évidements ont été remplis d'un deuxième matériau, on pourra prévoir une étape supplémentaire, illustrée en figure 1D, consistant à éliminer les portions restantes de la couche photosensible 6, 7 et 9. Pour éliminer les portions restantes de la couche photosensible on pourra, comme précédemment, former des ouvertures, dans cet exemple O3 et O4, dans la couche mince 3 au-dessus des portions à éliminer, les portions 5 et 9 dans cet exemple. Dans le cas où le type de couche photosensible choisi le permet, on pourra aussi prévoir de placer la structure dans un plasma (O₂, H₂, N₂) susceptible de modifier la structure des portions 5, 7 et 9 de la couche photosensible de façon que la couche photosensible s'élimine en passant à travers la couche mince 3. Dans cet exemple, la portion 7 est éliminée au travers de la couche mince 3.

Dans le cas où l'on a formé des ouvertures 03 et 04, on pourra prévoir une étape supplémentaire, consistant à remplir l'espace précédemment occupé par les portions 5, 7 et 9 d'un troisième matériau différent du deuxième matériau.

Ce procédé permet de former sous une couche d'un matériau donné des zones de vide et/ou des portions d'un autre matériau de toutes les formes souhaitées. De plus, l'insolation par un faisceau d'électrons étant une technique très précise, les formes des portions peuvent être définies avec une grande précision.

De plus, ce procédé n'endommage pas les portions ou couches définitives des structures réalisées.

Un mode de mise en oeuvre particulier du procédé est décrit ci-après dans un exemple de réalisation d'un transistor à grille entourante ou GAA (de l'anglais Gate All Around).

La figure 2 est une vue en perspective d'une structure intermédiaire obtenue après une étape d'un procédé classique de formation de transistors à grilles entourantes. Une zone active 100 d'un substrat semiconducteur 101 est délimitée par une région d'isolement 102 formée en surface du substrat 101. La zone active 100 a dans cet exemple une forme sensiblement rectangulaire en vue de dessus. Une couche de silicium forme un pont 103 passant par-dessus la zone active 100 et s'appuyant sur la région d'isolement 102 de part et d'autre de la zone active 100. La portion du pont 103 située au-dessus de la zone active 100 est monocristalline, la portion située au-dessus de la région d'isolement 102 est polycristalline. La zone active 100 et le pont 103 sont séparés par une zone de vide. La zone active 100 est visible en vue de dessus de chaque côté du pont 103.

La structure représentée en figure 2 est classiquement obtenue par croissance épitaxiale d'une couche de silicium/germanium au-dessus de la zone active 100 et croissance épitaxiale d'une couche de silicium monocristallin au-dessus de la couche de silicium germanium. Le bicouche est ensuite gravé de façon à former une bande transversale à la zone active 100. La portion restante de la couche de silicium germanium est éliminée par gravure et l'on obtient ainsi le pont de silicium 103.

Les figures 3A à 3F sont des vues en coupe des structures obtenues après des étapes successives d'un exemple de mise en oeuvre du procédé de la présente invention effectué à partir de la structure représentée en figure 2. Les vues en coupe sont réalisées selon un plan coupant le pont 103 longitudinalement.

Dans une première étape, illustrée en figure 3A, on fait croître par oxydation thermique une fine couche d'oxyde de silicium SiO₂ tout autour du pont de silicium 103 et sur la zone active 100. On dépose ensuite une couche photosensible 111 au dessus de la structure et dans l'espace vide situé entre le pont 103 et la zone active 100.

A l'étape suivante, illustrée en figure 3B, on insole la couche photosensible 111 en utilisant un faisceau d'électrons capable de traverser la couche photosensible située au dessus du pont 103, le pont 103 recouvert d'une fine couche d'oxyde de silicium et la couche photosensible placée sous le pont 103. Dans le cas où la couche photosensible est positive, on insole une portion 120 de la couche photosensible 111 située au-dessus de la partie centrale du pont 103 ainsi qu'une portion 121 de la couche photosensible 111 située à l'aplomb de la portion 120 sous le pont 103. On insole en outre des portions, non représentées, de la couche photosensible situées dans le prolongement des portions 120 et 121 de chaque côté du pont 103. Dans le cas où la couche photosensible est négative, on insole des portions 122 et 123 de la couche photosensible situées respectivement au-dessus des parties de gauche et de droite du pont 103 ainsi que des portions 124 et 125 situées respectivement au-dessous des parties de gauche et de droite du pont 103. On insole aussi des portions de la couche photosensible, non représentées, situées dans le prolongement des portions 122 à 125 de chaque côté du pont 123.

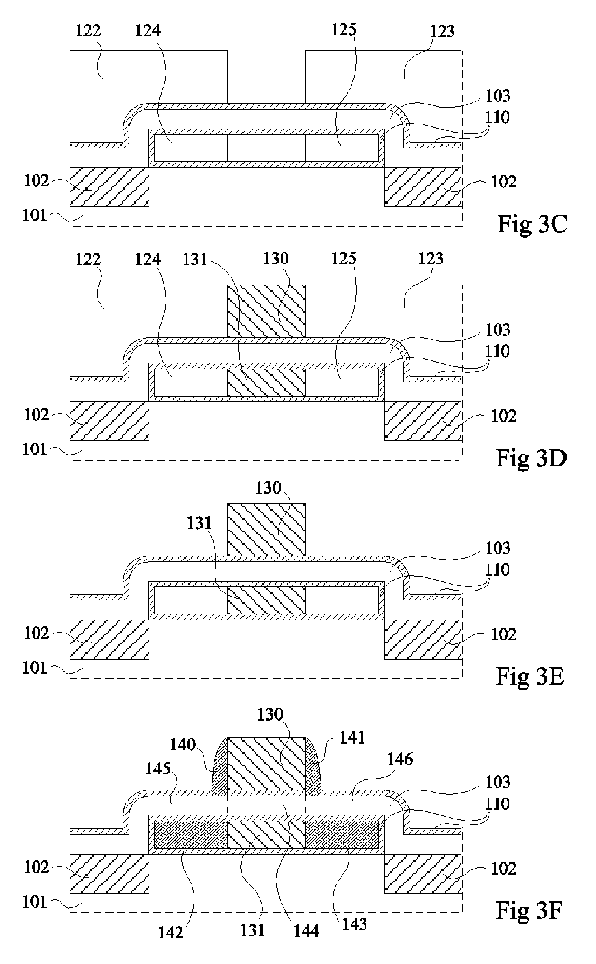

A l'étape suivante, illustrée en figure 3C, on élimine les portions 120 et 121 ainsi que les portions situées dans le prolongement des portions 120 et 121 de chaque côté du pont 103.

A l'étape suivante, illustrée en figure 3D, on dépose un matériau conducteur, par exemple du silicium polycristallin, dans l'espace précédemment occupé par les portions 120 et 121 et les portions placées dans le prolongement des portions 120 et 121 de chaque côté du pont 103. On obtient alors des portions de grille 130 et 131 respectivement au-dessus et au-dessous du pont 103 ainsi que des portions de grille, non représentées, de chaque côté du pont 103 dans le prolongement des portions 130 et 131. L'ensemble de ces portions constituent une même et unique grille entourant le pont 103.

A l'étape suivante, illustrée en figure 3E, on élimine les portions restantes de la couche photosensible, c'est à dire les portions 122 à 125 ainsi que les portions placées dans le prolongement des portions 122 à 125 de chaque côté du pont 103.

A l'étape suivante, illustrée en figure 3F, on effectue un dépôt de nitrure de façon à recouvrir entièrement la structure précédemment obtenue et à remplir les espaces vides situés sous le pont 103 de part et d'autre de la portion 131. On effectue ensuite une gravure anisotrope du nitrure jusqu'à découvrir la surface supérieure de la portion de grille 130, de la fine couche d'oxyde 110 placée sur le pont 103 et de la zone active 100 de part et d'autre du pont 103. Après cette gravure de nitrure, on a formé des espaceurs 140 et 141 sur les flancs de la portion 130 et des portions 142 et 143 de nitrure sous le pont 103 de part et d'autre de la portion de grille 131. La portion du pont 103 située entre les portions de silicium polycristallin 130 et 131 constitue le canal du transistor. Les portions du pont 103 situées de part et d'autre du canal 144 constituent des zones de source/drain 145 et 146.

Un avantage du procédé précédemment décrit est qu'il permet de réaliser un transistor à grille entourante tel que les portions de grille placées au-dessus et en dessous du pont de silicium soient alignées.

Un autre mode de mise en oeuvre du procédé est décrit ci-après dans un exemple de réalisation d'un réseau d'interconnections d'un circuit intégré.

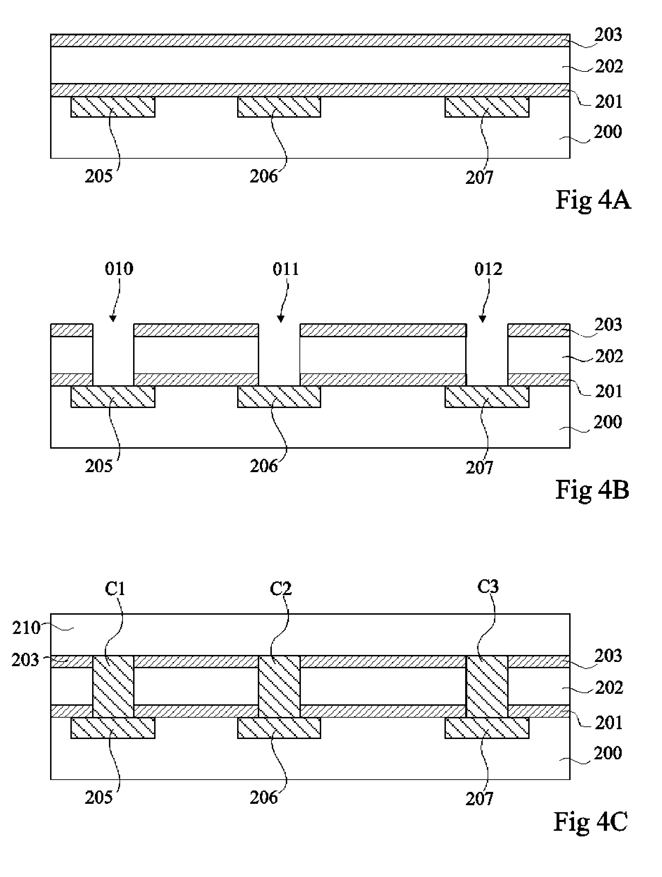

Dans une étape initiale, illustrée en figure 4A, on forme sur un substrat 200 un empilement d'une couche isolante 201, d'une couche photosensible 202 et d'une couche isolante 203. Le substrat 200 peut être n'importe quelle structure obtenue après une étape d'un procédé standard de formation d'un circuit intégré. A titre d'exemple, trois zones conductrices 205, 206 et 207 sont représentées en surface du substrat 200. Les zones conductrices 205, 206 et 207 sont par exemple des bornes d'accès à des composants du circuit intégré formés dans le substrat 200. Les couches isolantes 201 et 203 peuvent être de fines couches d'oxyde de silicium ou des couches d'un isolant présentant de préférence une faible constante diélectrique.

A l'étape suivante, illustrée en figure 4B, on forme des ouvertures O10, O11 et O12 dans l'empilement des couches 201 à 203 au dessus des zones conductrices 205, 206 et 207. Les ouvertures O10, O11 et O12 peuvent être formées selon un procédé comprenant les étapes suivantes. On dépose une couche de nitrure puis une couche photosensible sur la couche isolante 203. On insole et élimine des portions de la couche photosensible au-dessus des zones conductrices 205, 206 et 207. On grave les portions non protégées de la couche de nitrure. On grave successivement la couche isolante 203, la couche photosensible 202 et la couche isolante 201 selon un procédé de gravure anisotrope permettant de former des ouvertures ayant des parois sensiblement verticales. On élimine enfin les portions restantes de la couche de nitrure.

A l'étape suivante, illustrée en figure 4C, on remplit les ouvertures O10, O11 et O12 d'un matériau conducteur tel que du cuivre afin de former des contacts C1, C2 et C3 au-dessus des zones conductrices 205, 206 et 207. Le remplissage des ouvertures O10, O11 et O12 pourra consister à effectuer un dépôt de cuivre sur l'ensemble de la structure puis à effectuer un polissage mécano-chimique jusqu'à découvrir la couche isolante 203. On recouvre ensuite la couche isolante 203 et les contacts C1, C2 et C3 d'une couche photosensible 210.

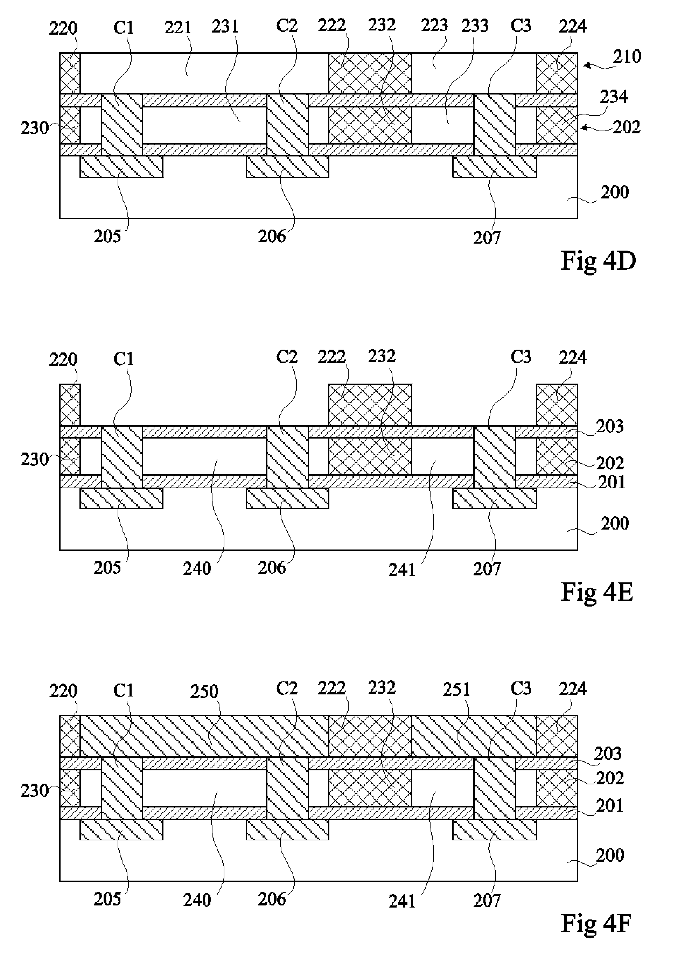

A l'étape suivante, illustrée en figure 4D, on insole les deux couches de la couche photosensible 202 et 210 avec un faisceau d'électrons passant à travers la couche photosensible 210, la couche isolante 203 et la couche photosensible 202. Dans cet exemple, on définit dans la couche photosensible 210 cinq portions 220, 221, 222, 223 et 224 de gauche à droite et on définit dans la couche photosensible 202 également cinq portions 230, 231, 232, 233 et 234 à l'aplomb respectivement des portions 220 à 224. La portion 221 s'étend au-dessus des contacts C1 et C2, la portion 223 est placée au-dessus du contact C3. Dans le cas où la couche photosensible est positive, on insole les portions 221, 223, 231 et 233. Dans le cas où la couche photosensible est négative, on insole les portions 220, 222, 224, 230, 232 et 234.

A l'étape suivante, illustrée en figure 4E, on élimine les portions 221 et 223 de la couche photosensible 210 selon un procédé de développement classique. On élimine ensuite les portions 231 et 233 en plaçant la structure dans un plasma de façon à ce que la couche photosensible se volatilise après transformation en passant à travers la couche isolante 203. Les portions éliminées de la couche photosensible sont alors remplacées par des zones de vide 240 et 241. Une autre façon d'éliminer les portions 231 et 233 consiste à former de petites ouvertures dans la couche isolante 203 au-dessus de ces portions, puis à les éliminer par gravure humide.

A l'étape suivante, illustrée en figure 4F, on remplit l'espace précédemment occupé par les portions 221 et 223 de la couche photosensible d'un matériau conducteur tel que du cuivre afin de former des lignes conductrices 250 et 251. La formation des lignes conductrices peut être effectuée en déposant du cuivre sur l'ensemble de la structure et en effectuant un polissage mécano-chimique jusqu'à découvrir la surface supérieure des portions 220, 222 et 224 de la couche photosensible. Les zones conductrices 205 et 206 sont alors reliées par l'intermédiaire des contacts C1 et C2 et de la ligne conductrice 250.

La suite d'étapes décrite précédemment consistant à former des contacts puis des lignes conductrices peut être répétée plusieurs fois afin de former plusieurs niveaux de lignes conductrices.

Un avantage du mode de mise en oeuvre particulier de la présente invention est qu'il permet de former un réseau d'interconnexions tel que chaque ligne conductrice soit isolée des autres lignes conductrices par deux très fines portions d'une couche isolante et par une zone de vide constituant le meilleur isolant possible.

De plus, l'isolement entre deux lignes placées sur deux niveaux successifs étant très bon, il est possible de diminuer la hauteur des contacts ce qui permet de réduire significativement leur résistance.

Bien entendu, la présente invention est susceptible de diverses variantes et modifications qui apparaîtront à l'homme de l'art. En particulier, on pourra prévoir de former sur un substrat un empilement de plusieurs couches photosensibles et de couches d'un ou de plusieurs matériaux donnés avant de procéder à une insolation de l'ensemble des couches photosensibles au moyen d'un faisceau d'électrons passant à travers l'ensemble des couches. En outre, divers procédés peuvent être mis en oeuvre pour former un empilement de couches photosensibles et de couches d'un ou de plusieurs matériaux.

## Revendications

1. Procédé de formation d'un réseau d'interconnexions d'un circuit intégré, comprenant les étapes suivantes :
recouvrir un substrat (200) d'un empilement d'une première couche isolante (201), d'une première couche sensible aux électrons (202), et d'une seconde couche isolante non sensible aux électrons (203) ;
former des ouvertures (010-012) dans l'empilement desdites couches ;
remplir les ouvertures d'un matériau conducteur (C1-C3) pour former des contacts ;
recouvrir la seconde couche isolante et les contacts d'une seconde couche sensible aux électrons (210) ;
insoler simultanément plusieurs paires de portions des première et seconde couches sensibles aux électrons ou leurs compléments selon que les couches sensibles aux électrons sont positives ou négatives, avec un faisceau d'électrons passant successivement à travers la seconde couche sensible aux électrons puis à travers la seconde couche isolante et enfin à travers la première couche sensible aux électrons, les portions d'une même paire étant superposées et placées au-dessus et au-dessous de la seconde couche isolante ; et
éliminer les paires de portions des couches sensibles aux électrons ; et
remplir d'un matériau conducteur l'espace précédemment occupé par les portions de chacune des paires situées au-dessus de la seconde couche isolante.

2. Procédé de formation d'un transistor à grille entourante, comprenant les étapes suivantes :
former un pont (103) en silicium monocristallin passant par-dessus une zone active d'un substrat semiconducteur, le pont étant posé sur une zone d'isolement entourant la zone active ;
former une fine couche d'oxyde de silicium (110) autour du pont et sur la zone active ;
recouvrir la structure d'une couche sensible aux électrons (111) ainsi que l'espace vide situé entre la zone active et le pont,
insoler simultanément deux portions de la couche sensible aux électrons, ou leurs compléments selon que la couche sensible aux électrons est positive ou négative, en utilisant un faisceau d'électrons capable de traverser successivement la couche sensible aux électrons située au-dessus du pont, puis le pont recouvert d'une fine couche d'oxyde de silicium, et enfin à travers la couche sensible aux électrons située au-dessous du pont, les deux portions de la couche sensible aux électrons étant superposées et placées au-dessus et au-dessous de la portion centrale du pont, et
éliminer les deux portions de la couche sensible aux électrons, et
remplir d'un matériau conducteur (130, 131) l'espace précédemment occupé par les deux portions pour former une grille ;
éliminer les portions restantes de la couche sensible aux électrons ;
recouvrir la structure d'une couche de nitrure ainsi que les espaces vides situés sous le pont de part et d'autre de la grille ; et
effectuer une gravure anisotrope du nitrure de façon à former des espaceurs (140, 141) sur les flancs de la portion de grille située au-dessus du pont.

3. Procédé selon la revendication 1, dans lequel l'élimination de la première portion de la première couche sensible aux électrons est effectuée au moyen d'un plasma, ladite première portion se volatilisant après transformation en passant à travers ladite seconde couche isolante non sensible aux électrons (203).

## Patentansprüche

1. Ein Verfahren zum Ausbilden eines Verbindungsnetzwerks, wobei das Verfahren die folgenden Schritte aufweist:
Abdecken eines Substrats (200) mit einem Stapel von einer ersten isolierenden Schicht (201), von einer ersten Elektronen empfindlichen Schicht (202), und von einer zweiten isolierenden, nicht Elektronen empfindlichen Schicht (203);
Ausbilden von Öffnungen (010-012) in dem Stapel von Schichten;
Füllen der Öffnungen mit einem leitenden Material (C1-C3) um Kontakte auszubilden;
Abdecken der zweiten isolierenden Schicht und der Kontakte mit einer zweiten Elektronen empfindlichen Schicht (210);
gleichzeitiges Belichten von mehreren Paaren von Teilen der ersten und zweiten Elektronen empfindlichen Schichten, davon abhängig ob die Elektronen empfindlichen Schichten positiv oder negativ sind, mit einem Elektronenstrahl der nacheinander durch die zweite Elektronen empfindliche Schicht, die zweite isolierende Schicht und die erste Elektronen empfindliche Schicht hindurch tritt, wobei die Teile von einem gleichen Paar überlagert sind und über und unter der zweiten isolierenden Schicht liegen, und
Entfernen der Paare von Teilen der Elektronen empfindlichen Schicht; und
Auffüllen des Raums, der zuvor durch die Teile von jedem der Paare, die über der zweiten isolierenden Schicht angeordnet sind eingenommen wurde, mit einem leitenden Material.

2. Ein Verfahren zum Ausbilden eines Gate-All-Around Transistors, wobei das Verfahren die folgenden Schritte aufweist:
Ausbilden einer Einkristall Siliziumbrücke (103), die sich über einen aktiven Bereich eines Halbleitersubstrats erstreckt, wobei die Brücke auf einen isolierenden Bereich, der den aktiven Bereich umgibt, gelegt ist;
Ausbilden einer dünnen Siliziumoxidschicht (110) um die Brücke und auf dem aktiven Bereich;
Abdecken der Struktur und des leeren Raums, der zwischen dem aktiven Bereich und der Brücke angeordnet ist, mit einer Elektronen empfindlichen Schicht (111),
gleichzeitiges Belichten von zwei Teilen der Elektronen empfindlichen Schicht oder deren Gegenstücke, davon abhängig ob die Elektronen empfindliche Schicht positiv oder negativ ist, durch Verwenden eines Elektronenstrahls, der geeignet ist nacheinander durch die Elektronen empfindliche Schicht, die oberhalb der Brücke angeordnet ist, die Brücke, die mit einer dünnen Siliziumoxidschicht überzogen ist, und die Elektronen empfindliche Schicht, die unterhalb der Brücke angeordnet ist hindurch zu treten, wobei die zwei Teile der Elektronen empfindlichen Schicht überlagert sind und über und unter dem zentralen Teil der Brücke liegen,
Entfernen der zwei Teile der Elektronen empfindlichen Schicht, und
Auffüllen des Raums mit einem leitenden Material (130, 131), der zuvor durch die zwei Teile eingenommen wurde, um ein Gate auszubilden;
Entfernen der restlichen Teile der Elektronen empfindlichen Schicht;
Abdecken der Struktur und des leeren Raums, der unter der Brücke auf beiden Seiten des Gateteils angeordnet ist, mit einer Nitridschicht; und
Ausführen einer anisotropischen Ätzung des Nitrids, um Abstandshalter (140, 141) auf den Seiten des Gateteils, der unter der Brücke angeordnet ist, auszubilden.

3. Das Verfahren nach Anspruch 1, wobei das Entfernen des Teils der Elektronen empfindlichen Schicht mittels eines Plasmas ausgeführt wird, wobei sich der erste Teil nach der Transformation verflüchtigt, und durch die zweite isolierende Schicht, die eine nicht Elektronen empfindliche Schicht (203) ist, hindurchtritt.

## Claims

1. A method for forming an interconnect network, comprising the steps of:
covering a substrate (200) with a stack of a first insulating layer (201), of a first electron-sensitive layer (202), and of a second insulating layer non electron-sensitive (203);
forming openings (010-012) in the stack of said layers;
filling the openings with a conductive material (C1-C3) to form contacts;
covering the second insulating layer and the contacts with a second electron-sensitive layer (210);
simultaneously insolating several pairs of portions of the first and second electron-sensitive layers according to whether the electron-sensitive layers are positive or negative, with an electron beam successively passing through the second electron-sensitive layer, the second insulating layer and the first electron-sensitive layer, the portions of a same pair being superposed and placed above and under the second insulating layer, and
removing the pairs of portions of electron-sensitive layer; and
filling with a conductive material the space previously taken up by the portions of each of the pairs located above the second insulating layer.

2. A method of forming a gate-all-around transistor, comprising the steps of:
forming a single-crystal silicon bridge (103) running above an active area of a semiconductor substrate, the bridge being laid on an insulation area surrounding the active area;
forming a thin silicon oxide layer (110) around the bridge and on the active area;
covering the structure and the empty space located between the active area and the bridge with an electron-sensitive layer (111),
simultaneously insolating two portions of the electron-sensitive layer or their complements according to whether the electron-sensitive layer is positive or negative, by using an electron beam capable of successively passing through the electron-sensitive layer located above the bridge, the bridge covered with a thin silicon oxide layer and the electron-sensitive layer located under the bridge, the two portions of the electron-sensitive layer being superposed and placed above and under the central portion of the bridge,
removing the two portions of the electron-sensitive layer, and
filling with a conductive material (130; 131) the space previously taken up by the two portions to form a gate;
removing the remaining portions of the electron-sensitive layer;
covering the structure and the empty spaces located under the bridge on either side of the gate with a nitride layer; and
performing an anisotropic etch of the nitride to form spacers (140, 141) on the sides of the gate portion located above the bridge.

3. The method of claim 1, wherein the removal of the portion of the electron-sensitive layer is performed by means of a plasma, said first portion volatilizing after transformation in crossing said second insulating layer non sensitive to electrons (203).
